# EUROPÄISCHE PATENTSCHRIFT

(11) **EP 1 505 638 B1**
(45) Veröffentlichungstag und Bekanntmachung des Hinweises auf die Patenterteilung: **29.02.2012**
(21) Anmeldenummer: 04101940.7
(22) Anmeldetag: 05.05.2004
(51) Int. Cl.: H01L 23/544, H01L 21/288

(54) **Verfahren zur Herstellung eines bruchfesten, scheibenförmigen Gegenstands sowie zugehörige Halbleiterschaltungsanordnung**
Method of producing of a break-proof plate-like object, and corresponding semiconductor circuit
Méthode de formation d'un objet en forme de disque résistant à la rupture, et circuit semiconducteur correspondant

(30) Priorität: 12.06.2003 DE 10326508
(43) Veröffentlichungstag der Anmeldung: 09.02.2005
(73) Patentinhaber: Infineon Technologies AG, 85579 Neubiberg (DE)
(72) Erfinder: Grassmann, Andreas, 9500 Villach (AT)
(74) Vertreter: Karl, Frank

(56) Entgegenhaltungen:
- EP-A- 1 489 656
- US-A- 5 104 820
- US-A- 5 618 752
- US-A- 5 691 248
- US-A- 6 093 966
- US-A1- 2002 127 868
- US-A1- 2003 085 460
- US-A1- 2003 102 563

## Beschreibung

Die vorliegende Erfindung bezieht sich auf ein Verfahren zur Herstellung eines bruchfesten scheibenförmigen Gegenstands und insbesondere auf ein Verfahren zur galvanischen Herstellung eines ultradünnen bruchfesten Halbleiterwafers mittels eines sogenannten "seed layers", wie er bei der Herstellung von integrierten Halbleiterschaltungen verwendet wird.

Für eine Vielzahl von gegenwärtigen und zukünftigen Anwendungen von elektronischen Bauelementen und insbesondere von integrierten Schaltungen (IC, integrated circuit) ist es vorteilhaft, die Gesamtdicke dieser integrierten Schaltungen bzw. Halbleiterschaltungen auf wenige Mikrometer zu beschränken. Derart dünne Halbleiterschaltungen bzw. Chips haben eine sehr geringe Masse und eine sehr geringe Bauhöhe, weshalb sie für eine Vielzahl von Anwendungsfeldern beispielsweise in zukünftiger Wegwerfelektronik sowie für Chipkarten und Smartcards von Bedeutung sind.

Insbesondere die Entwicklung von Leistungshalbleitern erfordert zur Optimierung der Durchlasswiderstände immer dünnere Substratdicken der in Durchlassrichtung, d.h. Vorder- zu Rückseiten, betriebenen Halbleiterbauelemente bzw. Bausteine. Diese dünnen Halbleiterwafer, welche derzeit beispielsweise ca. 70 µm für einen 150 mm Wafer aufweisen, sind mechanisch sehr empfindlich, verbiegen sich durch innere Spannungen und brechen leicht. Daraus ergibt sich eine hohe Bruchrate, die eine weitere Dünnung der Halbleiterwafer insbesondere bei größeren Waferdurchmessern von zukünftig 300 mm verhindert.

Insbesondere bei Halbleiterwafern wird demzufolge eine äußere Belastung auch durch eine Beanspruchung bzw. den Stress einer Oxidschicht an einer Vorderseite eines Halbleiterwafers erhöht. Demzufolge gibt es auch mechanische Beanspruchungen, insbesondere nach der äußeren Krafteinwirkung durch eine Auflagereaktion beispielsweise beim Ablegen eines Halbleiterwafers in einer Horde oder dem Ansaugen eines verbogenen Dünnwafers auf einem Vakuumchuck.

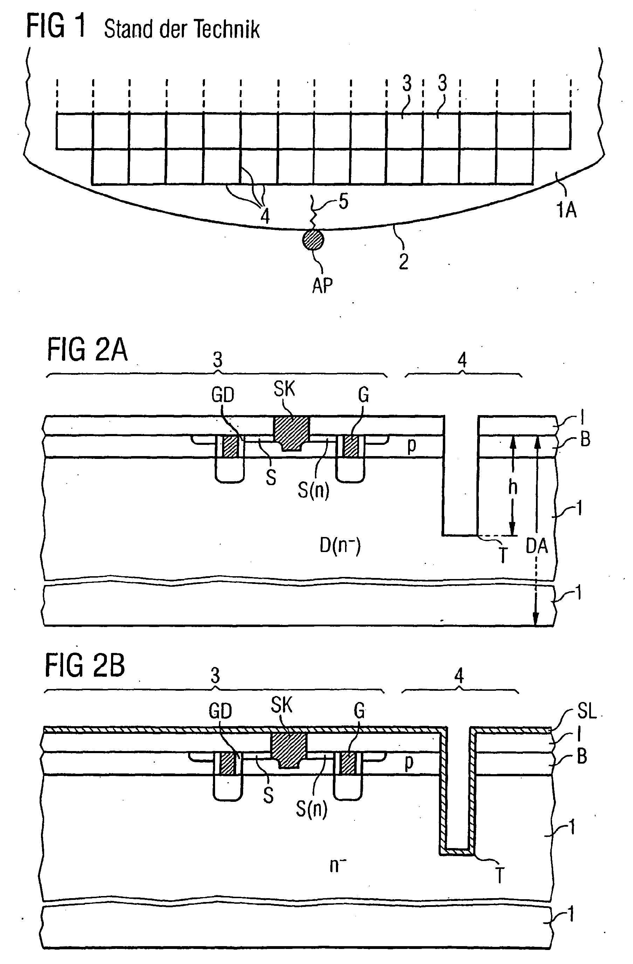

Figur 1 zeigt eine Teil-Draufsicht eines derartigen scheibenförmigen Gegenstands, wie er beispielsweise als ultradünner Halbleiterwafer 1A bekannt ist.

Gemäß Figur 1 wird der ultradünne Halbleiterwafer 1A, der eine Vielzahl von integrierten Halbleiterschaltungen bzw. Chips 3 mit dazwischen liegenden Säge- bzw. Ritzrahmen 4 aufweist, über seinen Umfangsrand 2 auf einen Auflagepunkt AP beispielsweise in einer Horde angelegt. Unter einem Säge- bzw. Ritzrahmen 4 wird nachfolgend der Abstand zwischen zwei Halbleiterschaltungen 3 verstanden, der üblicherweise zum Vereinzeln bzw. Sägen benötigt wird. An diesem Auflagepunkt AP werden demzufolge Auflagereaktionen erzeugt, woraus sich unerwünschte Schubspannungen ergeben. Da jedoch insbesondere monokristallines Halbleitermaterial wie beispielsweise Silizium, welches üblicherweise für Halbleiterwafer verwendet wird, nahezu keine Schubspannungen aushält, entsteht nun gemäß Figur 1 ein Haarriss 5 im Bereich des Auflagepunktes AP. Derartige Haarrisse 5 pflanzen sich sehr leicht insbesondere in ultradünnen Halbleiterwafern 1A fort, weshalb sie eine wesentliche Ursache für die außerordentlich hohe Bruchgefahr bei derartigen ultradünnen Halbleiterwafern darstellen.

Zur Vermeidung einer derartigen Zerbrechlichkeit von ultradünnen Halbleiterwafern wurden entweder speziell adaptierte Transportvorrichtungen und sogenannte Chucks in den Bearbeitungsmaschinen mit beispielsweise speziellen Transporthorden zur Verfügung gestellt, wobei ein Waferbruch nur reduziert, jedoch nicht ausgeschlossen werden kann. Insbesondere mit der Zunahme eines Durchmessers von Halbleiterwafern von 150 mm auf über 300 mm können derartige Probleme jedoch nicht vollständig beseitigt werden.

Gemäß einer alternativen Lösungsmöglichkeit werden Trägerwafer verwendet, wobei ein ultradünner Produktwafer auf einem normal dicken Trägerwafer mit hoch- oder mitteltemperaturfesten Verbindungsmaterialien verbunden wird. Nachteilig bei einer derartigen Trägertechnik sind jedoch die zusätzlichen Investitionen sowie die hohen Herstellungskosten.

Ein weiterer Ansatz, die Zerbrechlichkeit insbesondere von ultradünnen Halbleiterwafern zu vermindern, ist beispielsweise das Nachbearbeiten der Kante bzw. des Umfangsrandes mit einem kombinierten Wasserstrahl-Laserschneidegerät. Der Waferbruch lässt sich jedoch nur um einen bestimmten Prozentsatz verringern.

Weiterhin ist aus der Druckschrift US 2003/0102563 A1 eine Halbleiterschaltungsanordnung sowie ein zugehöriges Herstellungsverfahren bekannt mit einem Trägersubstrat, einer Galvanik-Keimschicht und einem Galvanik-Füllmaterial, das an der Oberfläche der Galvanik-Keimschicht galvanisch ausgebildet ist. Die Anordnung umfasst weiterhin ein schubspannungsfestes Material. Eine solche Halbleiterschaltungsanordnung zeigt eine verringerte Empfindlichkeit gegenüber Schubspannungen, die von dem Galvanik-Füllmaterial in das darunterliegende Substrat induziert werden, indem das schubspannungsfeste Material als Pufferschicht zwischen Galvanik-Füllmaterial und Substrat wirkt.

Ferner ist aus der Druckschrift US 5,691,248 A ein Verfahren zum präzisen Trennen eines Wafers in einzelne Chips bekannt, wobei in dem Wafer entlang der späteren Kanten Gräben ausgebildet und mit Polyimid gefüllt werden. Durch Dünnen des Wafers von der Rückseite und Entfernen des Polyimids wird der Wafer in einzelne Chips geteilt.

Demgegenüber liegt der Erfindung die Aufgabe zu Grunde, ein Verfahren zur Herstellung eines bruchfesten scheibenförmigen Gegenstandes bereitzustellen, wobei die Zerbrechlichkeit insbesondere von ultradünnen scheibenförmigen Gegenständen wesentlich verringert ist.

Erfindungsgemäß wird diese Aufgabe durch die Maßnahmen des Patentanspruchs 1 gelöst.

Insbesondere durch das Ausbilden von zumindest einem Graben im Bereich eines Sägerahmens an einer Vorderseite des Trägersubstrats bzw. Substrats, dem Ausbilden einer elektrisch leitenden Galvanik-Keimschicht an der Oberfläche des Substrats und des Grabens, dem Ausbilden einer Galvanisierungsmaske zumindest im Bereich des Grabens, dem Durchführen einer Galvanisierung zum Auffüllen der nicht maskierten Bereiche mittels der Galvanik-Keimschicht, dem Entfernen der Galvanisierungsmaske und der darunter liegenden Galvanik-Keimschicht und dem Auffüllen des Grabens mit Polyimid oder Fotoimid sowie einem nachfolgenden Dünnen des Substrats bis auf eine Enddicke, die kleiner ist als die Grabentiefe des Grabens, können die für die Zerbrechlichkeit von ultradünnen Halbleiterwafern verantwortlichen Schubspannungen sehr effektiv aufgefangen werden, wodurch ein Waferbruch wesentlich verringert ist. Hierbei ermöglicht das an der Oberfläche des Substrats ausgebildete Galvanik-Füllmaterial gemeinsam mit dem schubspannungsfesten Material, d.h. dem Polyimid oder Fotoimid, erstmalig auch ein Dünnen des scheibenförmigen Gegenstands auf Enddicken unterhalb von 10 µm.

Vorzugsweise werden als Substrate bzw. Trägersubstrate Halbleiterwafer und insbesondere Silizium-Wafer von einem ersten Leitungstyp verwendet und darin vertikale Leistungstransistoren ausgebildet. Auf diese Weise können insbesondere Leistungshalbleiterbauelemente besonders einfach und effektiv hergestellt werden.

Vorzugsweise wird mittels eines PVD-Verfahrens die Galvanik-Keimschicht ganzflächig an der Oberfläche des Trägersubstrats ausgebildet, wobei sie insbesondere eine Diffusionsbarrierenschicht zur Vermeidung eines Eindringens von Verunreinigungen in das Halbleitermaterial aufweist. Die Galvanik-Keimschicht weist beispielsweise eine TaN/Cu- oder alternativ eine TiN/Cu-Schichtenfolge mit einer Dicke kleiner 100 nm auf. Auf diese Weise erhält man eine für die Galvanisierung notwendige und hochwirksame Anschlusselektrode an der Oberfläche des Trägersubstrats und der Gräben.

Als Galvanisierungsmaske wird vorzugsweise ein fotosensitiver Lack mit einer Dicke von 20 µm bis 200 µm ganzflächig aufgeschleudert sowie in den Graben eingebracht und anschließend fotolithographisch strukturiert. Insbesondere bei Verwendung eines Negativresists als fotosensitiven Lack erhält man hierbei die gewünschten sehr steilen Flanken nach der Strukturierung des Fotolacks.

Als Galvanik-Füllmaterial wird vorzugsweise eine Vielzahl von galvanischen Metallschichten galvanisch ausgebildet, wobei insbesondere eine Cu/NiP-Schichtenfolge für "wire bond" oder eine Cu/AuSn-Schichtenfolge für Lötprozesse eine ausreichende mechanische Stabilität und eine hohe Leitfähigkeit bei guter Lötbarkeit aufweist.

In den weiteren Unteransprüchen sind weitere vorteilhafte Ausgestaltungen der Erfindung gekennzeichnet.

Die Erfindung wird nachstehend anhand eines Ausführungsbeispiels unter Bezugnahme auf die Zeichnung näher beschrieben.

Es zeigen:
Figur 1 eine vereinfachte Teil-Draufsicht eines herkömmlichen Halbleiterwafers mit Haarriss;
Figuren 2A bis 2F vereinfachte Teil-Schnittansichten zur Veranschaulichung wesentlicher Verfahrensschritte bei der Herstellung eines bruchfesten Halbleiterwafers gemäß der vorliegenden Erfindung; und
Figur 3 eine vereinfachte Draufsicht eines bereits vereinzelten Halbleiterbausteins hergestellt gemäß der vorliegenden Erfindung.
Figuren 2A bis 2F zeigen vereinfachte Teil-Schnittansichten zur Veranschaulichung wesentlicher Verfahrensschritte bei der Herstellung eines bruchfesten Halbleiterwafers gemäß der vorliegenden Erfindung; und

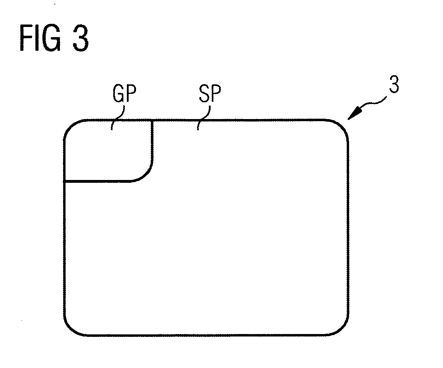

Figur 3 eine vereinfachte Draufsicht eines bereits vereinzelten Halbleiterbausteins hergestellt gemäß der vorliegenden Erfindung.
Figuren 2A bis 2F zeigen vereinfachte Teil-Schnittänsichten zur Veranschaulichung wesentlicher Verfahrensschritte bei der Herstellung eines bruchfesten Halbleiterwafers gemäß der vorliegenden Erfindung, wobei gleiche Bezugszeichen gleiche oder entsprechende Elemente wie in Figur 1 bezeichnen und auf eine wiederholte Beschreibung nachfolgend verzichtet wird.

Gemäß Figur 2A besteht ein Trägersubstrat 1 beispielsweise aus einem Halbleiterwafer und insbesondere aus einem monokristallinen Silizium-Halbleiterwafer von einem ersten Leitungstyp n⁻ mit einer herkömmlichen Anfangsdicke D_{A} von ca. 500 bis 1000 µm. Ferner können beispielsweise im Trägersubstrat 1 Halbleiterbauelemente wie beispielsweise vertikale Leistungstransistoren mit einem Sourcegebiet S, einem Gate G und einem Drain D ausgebildet sein, wobei im vorliegenden Ausführungsbeispiel ein in einem Graben ausgebildeter vertikaler Leistungstransistor im Halbleitersubstrat 1 derart ausgebildet ist, dass sein Draingebiet D im Wesentlichen dem Halbleitersubstrat 1 entspricht, an dessen Oberfläche ein Transistorbody B als p-Wanne ausgebildet ist, wobei wiederum an der Oberfläche des Transistorbodys B die Sourcegebiete S sowie ein zugehöriger Sourcekontakt SK zum Anschließen der Sourcegebiete S ausgebildet sind. Zur Realisierung des vertikalen Leistungstransistors befinden sich ferner Gräben an der Oberfläche des Trägersubstrats 1, die über den Transistorbody B hinaus in das Halbleitersubstrat 1 reichen. Im oberen Bereich weisen diese Gräben beispielsweise an ihrer Grabenoberfläche ein Gatedielektrikum GD und eine elektrisch leitende Gateschicht vorzugsweise aus hochdotiertem Polysilizium als Gate G auf, wodurch sich ein vertikales Kanalgebiet entlang der Gräben im Transistorbody B realisieren lässt. Zur Isolierung weist eine derartige Bauelementstruktur ferner eine Isolierschicht I an der Oberfläche des Halbleitersubstrats auf, die vorzugsweise als SiO₂-Schicht thermisch ausgebildet ist.

Zur Erhöhung einer Bruchfestigkeit wird gemäß Figur 2A zunächst im Bereich des Sägerahmens bzw. Ritz-Rahmens 4 zumindest ein tiefer Graben T mit einer Grabentiefe h von beispielsweise 5 bis 200 µm an der Vorderseite des Trägersubstrats bzw. Halbleiterwafers 1 ausgebildet.

Da der Sägerahmen gemäß Figur 1 im Wesentlichen eine gitterförmige Struktur aufweist und die einzelnen integrierten Schaltungen bzw. Halbleiterbausteine 3 voneinander beabstandet sind, besitzen auch die im Bereich des Sägerahmens 4 ausgebildeten Gräben T im Wesentlichen eine gitterförmige Struktur. Die Ausbildung der im Wesentlichen matrixförmigen, d.h. in Zeilen und Spalten ausgebildeten Gräben T kann beispielsweise durch Plasmaätzen, nasschemisches Ätzen in einer Kalilauge, lichtinduziertes Ätzen, anodisches Siliziumätzen, Laserschneiden und/oder mechanisches Sägen realisiert werden.

Eine Grabenbreite wird hierbei in Abhängigkeit von einem verwendeten Füllmaterial derart dimensioniert, dass das später einzubringende Füllmaterial möglichst einfach in die Gräben T eingebracht werden kann. Vorzugsweise besitzen die Gräben T eine Grabenbreite von 5 bis 100 µm und können demzufolge problemlos innerhalb des Sägerahmens 4 untergebracht werden.

Gemäß Figur 2B wird in einem nachfolgenden Schritt eine elektrisch leitende Galvanik-Keimschicht bzw. eine sogenannte Galvanik Seed Layer SL an der Oberfläche des Trägersubstrats und somit auch an der Oberfläche des Grabens T ausgebildet. Diese Galvanik-Keimschicht SL stellt hierbei einen Elektrodenanschluss für das später durchzuführende elektrochemische Galvanisieren dar, wobei sie insbesondere zur Vermeidung einer Eindiffusion von Verunreinigungen aus einer galvanisch abgeschiedenen Metallschicht vorzugsweise eine Diffusionsbarrierenschicht aufweist. Beispielsweise wird eine TaN/Cu- oder alternativ eine TiN/Cu-Schichtenfolge als sogenannte "Seed Layer" bzw. Keimschicht SL mit einer Dicke kleiner 100 nm mittels eines PVD-Verfahrens (Physical Vapor Deposition) bzw. mittels Sputterns ganzflächig aufgebracht.

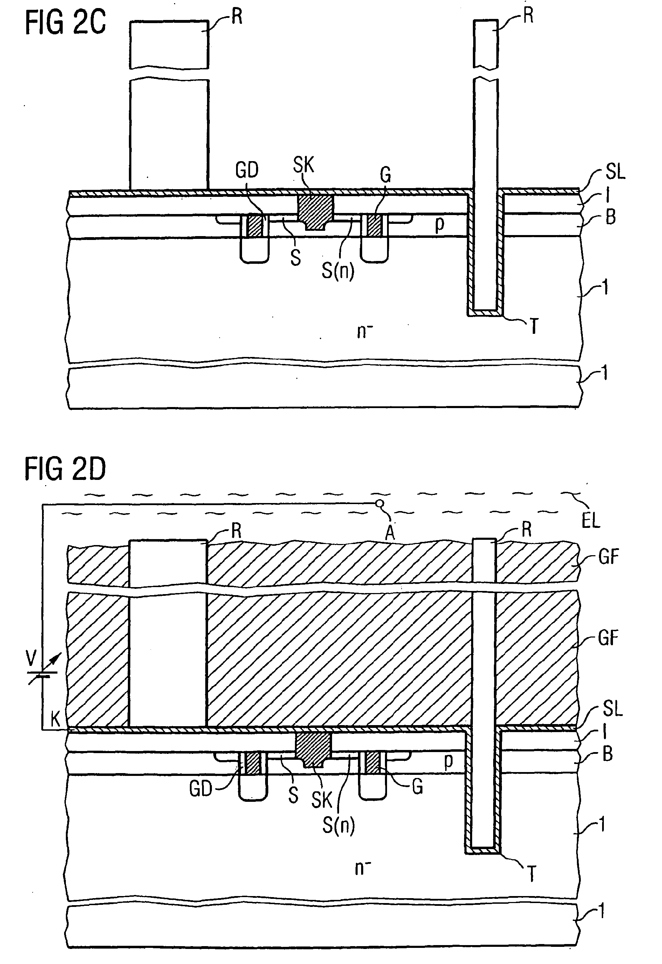

Gemäß Figur 2C wird nach dem Ausbilden der Galvanik-Keimschicht SL eine Galvanisierungsmaske R mit freiliegenden Galvanik-Bereichen an der Oberfläche der Galvanik-Keimschicht SL zumindest im Bereich des Sägerahmens 4 ausgebildet. Vorzugsweise wird hierbei ein Fotolack mit einer Dicke von 20 µm bis 200 µm aufgeschleudert, und fotolithographisch strukturiert. Insbesondere bei Verwendung eines Negativlacks bzw. Negativresists mit einer Dicke von ca. 150 µm und einer nachfolgenden Belichtung mittels eines "EVG Proximity Printers" erhält man für die Galvanisierungsmaske R die gewünschten besonders steilen Flanken. Als Negativlack kann beispielsweise der von Sumitomo vertriebene Fotolack "Su8" verwendet werden. Die Belichtungsmaske für diese Galvanisierungsmaske R entspricht hierbei üblicherweise einer Maske für eine erste Metallisierungsebene, weshalb erfindungsgemäß keine zusätzlichen Belichtungsmasken benötigt werden.

Obwohl die Galvanisierungsmaske im Bereich des Sägerahmens gemäß Figur 2C genau eine Breite des Grabens T aufweist, kann sie an dieser Stelle auch insbesondere breiter als der Graben T sein. Da jedoch die Galvanisierungsmaske S zumindest im Bereich des Sägerahmens 4 bereits in den Graben eingebracht wird, dient sie bereits als stabilisierendes Material, wodurch die Bruchfestigkeit insbesondere von Halbleiterwafern für die Handhabung bereits grundsätzlich verbessert ist.

Gemäß Figur 2D wird anschließend eine Galvanisierung der Galvanik-Keimschicht SL zum Auffüllen der frei liegenden Galvanik-Bereiche bzw. der zwischen der Galvanisierungsmaske R freiliegenden Bereiche mit einem Galvanik-Füllmaterial GF durchgeführt. Hierzu wird der Halbleiterwafer bzw. das Trägersubstrat mit seiner darauf ausgebildeten Galvanisierungsmaske R in ein Elektrolytbad EL gebracht und die elektrisch leitende Galvanik-Keimschicht SL als Kathode bzw. Galvanisierungselektrode an eine Stromversorgung V angeschlossen. Andererseits wird auch eine im Elektrolytbad EL eingebrachte Gegenelektrode A als Anode ebenfalls an die Stromversorgung V angeschlossen, wodurch eine galvanische Abscheidung auf der Galvanik-Keimschicht SL durchgeführt werden kann.

Auf diese Weise wächst ein Galvanisierungsmetall als sogenanntes Galvanik-Füllmaterial GF in den freiliegenden Bereichen der Galvanisierungsmaske R auf, wobei vorzugsweise bis zur Höhe bzw. einem Niveau der Galvanisierungsmaske R ein Galvanik-Füllmaterial GF galvanisch ausgebildet wird. Vorzugsweise werden eine Vielzahl von galvanischen Metallschichten als Galvanik-Füllmaterial GF an der Oberfläche der frei liegenden Galvanik-Keimschicht SL abgeschieden, wodurch man hohe mechanische Festigkeiten sowie hervorragende Leitfähigkeiten bei einer optimalen Lötbarkeit der obersten Metallfläche erhält. Insbesondere eine Cu/NiP-Schichtenfolge als Galvanik-Füllmaterial GF weist hierbei außerordentlich hohe mechanische Festigkeit bei hoher Leitfähigkeit für sogenannte "wire bond"-Verfahren auf, während eine alternative Cu/AuSn-Schichtenfolge optimale Löteigenschaften besitzt. Insbesondere an der Oberfläche des Galvanik-Füllmaterials GF sollten Metallverbindungen bzw. Metallkombinationen mit hoher Festigkeit und guter Lötbarkeit verwendet werden wie beispielsweise eutektische Materialien aus Gold und Zinn oder aus Silber und Zinn.

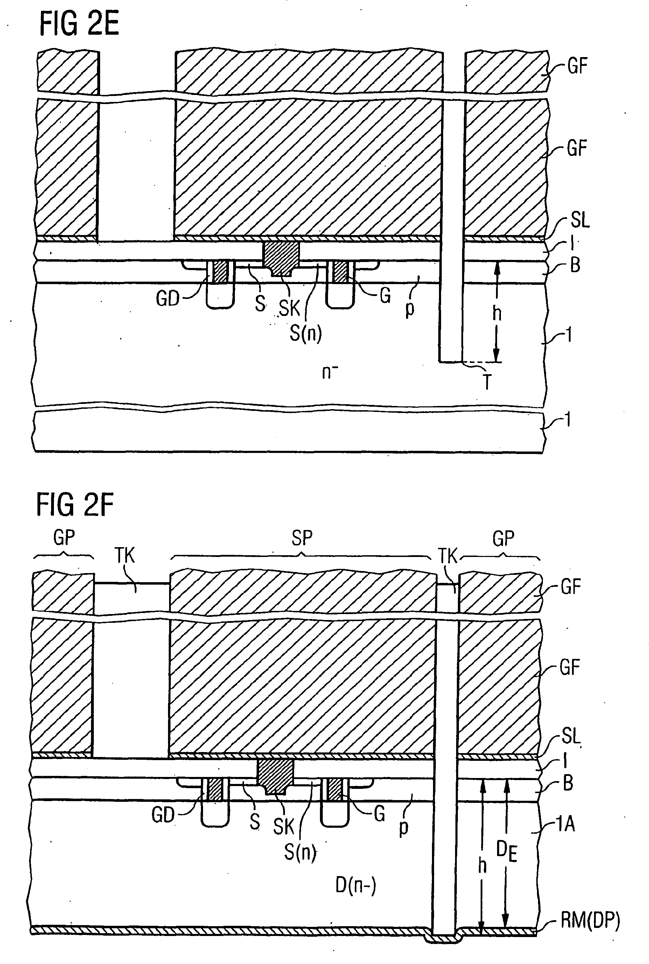

Nach dem Entfernen der Elektrodenanschlüsse und dem Herausnehmen des Halbleiterwafers aus dem Elektrolytbad EL wird gemäß Figur 2E die Galvanisierungsmaske R und die darunter liegende Galvanik-Keimschicht SL zum Ausbilden von schubspannungsfesten Bereichen entfernt. Im Einzelnen wird hierbei der Fotolack bzw. Fotoresist mittels Plasmaätzens und nachfolgendem nasschemischen Ätzens entfernt bzw. gestrippt. Anschließend werden die so freigelegten Bereiche der Galvanik-Keimschicht SL ebenfalls nasschemisch geätzt, wobei auch das Galvanik-Füllmaterial GF leicht angeätzt werden kann. Das Galvanik-Füllmaterial GF dient hierbei als Maske für das Entfernen des Fotolacks und der darunter liegenden Galvanik-Keimschicht.

Gemäß Figur 2F werden anschließend die freigelegten Bereiche bzw. schubspannungsfesten Bereiche mit einem schubspannungsfesten Material TK, d.h. mit Polyimid oder Fotoimid, aufgefüllt. Polyimid oder Fotoimid wird ganzflächig aufgeschleudert und anschließend zurückgeätzt oder mittels Belichtung strukturiert. Auf diese Weise erhält man zumindest im Bereich des Sägerahmens und der darin ausgebildeten Gräben T eine Auffüllung mit dem schubspannungsfesten Material TK, welches einerseits die mechanische Stabilität weiter verbessert und andererseits als Passivierung bzw. Isolierung zwischen den metallischen bzw. elektrisch leitenden galvanischen Füllmaterialien wirkt. Insbesondere dient dieses schubspannungsfeste Material TK jedoch als Puffer für mechanische Spannungen, wie sie insbesondere auf Grund von unterschiedlichen Ausdehnungskoeffizienten bei einer thermischen Behandlung auftreten können.

Gemäß Figur 2F erfolgt weiterhin ein Dünnen des Trägersubstrats von seiner Rückseite bis zu einer Enddicke D_{E} zur Realisierung eines gedünnten Trägersubstrats 1A, wobei die Enddicke D_{E} des gedünnten Trägersubstrats 1A kleiner ist als die Grabentiefe h des Grabens T. Vorzugsweise wird hierbei ein mechanisches Schleifen mit nachfolgendem nasschemischem Ätzen durchgeführt, wobei das freigelegte schubspannungsfeste Material TK als Ätzstopp und/oder Justiermarke verwendet werden kann. Das nasschemische Rückätzen dient hierbei insbesondere zur Beseitigung von mechanischen Spannungen, die während des Schleifvorgangs im Halbleitermaterial erzeugt werden. Abschließend kann an der Rückseite des gedünnten Trägersubstrats 1A eine Rückseitenmetallisierung RM ausgebildet werden, die im vorliegenden Fall als Drainanschluss für das Draingebiet D des Leistungshalbleiters wirkt. Auf diese Weise erhält man einen bruchfesten scheibenförmigen Gegenstand und insbesondere einen bruchfesten Halbleiterwafer, bei dem anstatt der üblichen Aluminium-Metallisierung mittels LIGA-Technik eine dicke (vorzugsweise größer 100 µm) Metallplattierung galvanisch ausgebildet wird. Die elektrische Isolierung der Metallplattierung, die gleichzeitig die "Bond Pads" bzw. Anschlussflächen für eine Lötverbindung darstellen, erfolgt hierbei durch schubspannungsfestes Material und insbesondere durch Polymerschichten der gleichen Dicke. Zum Abbau der mechanischen Verspannungen über dem gesamten Halbleiterwafer wird dieses schubspannungsfeste Material insbesondere auch in den Zwischenräumen zwischen den Chips bzw. Halbleiterbausteinen 3, d.h. im Sägerahmen 4 ausgebildet.

Figur 3 zeigt eine vereinfachte Draufsicht eines bereits vereinzelten Halbleiterbausteins bzw. Chips 3 gemäß der vorliegenden Erfindung, wobei gleiche Bezugszeichen gleiche oder entsprechende Elemente bezeichnen, weshalb auf eine wiederholte Beschreibung nachfolgend verzichtet wird.

Gemäß Figur 3 erhält man somit einen äußerst einfachen Leistungshalbleiterbaustein mit einem in einer Ecke des Bausteins ausgebildeten Gate-Anschlussbereich bzw. Gatepad GP und einem im übrigen Bereich ausgebildeten Source-Anschlussbereich bzw. Sourcepad SP. Während der Source-Anschlussbereich SP über die in Figur 2F dargestellten Sourcekontakte FK und die Galvanik-Keimschicht SL direkt mit den im Halbleitersubstrat 1A ausgebildeten Leistungstransistoren bzw. deren Sourcegebieten S in Verbindung steht, ist der Gate-Anschlussbereich GP über das schubspannungsfeste Material TK elektrisch isoliert vom Source-Anschlussbereich SP und lediglich an einem nicht dargestellten Bereich mit den in den Gräben verlaufenden Gateschichten G elektrisch verbunden. Ein Drain-Anschlussbereich bzw. Drain Pad DP ist hierbei identisch mit der Rückseitenmetallisierung RM und somit mit dem gedünnten Halbleitersubstrat elektrisch verbunden, welches das Draingebiet D realisiert. Auf diese Weise erhält man eine insbesondere hinsichtlich seiner Durchlasswiderstände optimierten Leistungshalbleiterschaltung mit außerordentlich geringen Substratdicken, weshalb insbesondere ein Drain-Anschlusswiderstand wesentlich verringert werden kann. Eine Bruchfestigkeit ist hierbei auf Grund der hohen Dicken für das schubspannungsfeste Material TK und das Galvanik-Füllmaterial GF jederzeit gegeben.

Die Erfindung wurde vorstehend anhand eines Silizium-Halbleiterwafers beschrieben. Sie ist jedoch nicht darauf beschränkt und umfasst in gleicher Weise auch andere Trägersubstrate.

## Patentansprüche

1. Verfahren zur Herstellung eines bruchfesten scheibenförmigen Gegenstands mit den Schritten:
a) Vorbereiten eines Substrats (1, B, I) mit einer Anfangsdicke (D_{A}) und einem Sägerahmen (4);
b) Ausbilden von zumindest einem Graben (T) mit einer Grabentiefe (h) im Bereich des Sägerahmens (4) an einer Vorderseite des Substrats (1, B, I);
c) Ausbilden einer elektrisch leitenden Galvanik-Keimschicht (SL) an der Oberfläche des Substrats und des Grabens (T);
d) Ausbilden einer Galvanisierungsmaske (R) zumindest im Bereich des Grabens (T);
e) Durchführen einer Galvanisierung zum Auffüllen der nicht maskierten Bereiche mittels der Galvanik-Keimschicht (SL);
f) Entfernen der Galvanisierungsmaske (R) und der darunterliegenden Galvanik-Keimschicht (SL) zum Freilegen des Grabens (T) :
g) Auffüllen des Grabens (T) mit Polyimid oder Fotoimid; und
h) Dünnen des Substrats (1) von seiner Rückseite bis zu einer Enddicke (D_{E}) zur Realisierung eines gedünnten Substrats (1A), wobei die Enddicke (D_{E}) des gedünnten Substrats (1A) kleiner ist als die Grabentiefe (h) des Grabens (T).

2. Verfahren nach Patentanspruch 1,
**dadurch gekennzeichnet, dass** in Schritt a) in einem Halbleiterwafer (1) von einem ersten Leitungstyp (n⁻) vertikale Leistungstransistoren (S, G, D) ausgebildet werden.

3. Verfahren nach Patentanspruch 1 oder 2,
**dadurch gekennzeichnet, dass** in Schritt b) ein Laserschneiden, Plasmaätzen, nasschemisches Ätzen, lichtinduziertes Ätzen, anodisches Ätzen und/oder Sägen durchgeführt wird.

4. Verfahren nach einem der Patentansprüche 1 bis 3,
**dadurch gekennzeichnet, dass** in Schritt c) ein PVD-Verfahren zum ganzflächigen Ausbilden der Galvanik-Keimschicht (SL) durchgeführt wird.

5. Verfahren nach Patentanspruch 4,
**dadurch gekennzeichnet, dass** die Galvanik-Keimschicht (SL) eine Diffusionsbarrierenschicht aufweist.

6. Verfahren nach Patentanspruch 4 oder 5,
**dadurch gekennzeichnet, dass** die Galvanik-Keimschicht (SL) eine TaN/Cu- oder TiN/Cu-Schichtenfolge mit einer Dicke kleiner 100nm aufweist.

7. Verfahren nach einem der Patentansprüche 1 bis 6,
**dadurch gekennzeichnet, dass** in Schritt d) ein fotosensitiver Lack mit einer Dicke von 20µm bis 200µm ganzflächig aufgeschleudert sowie in den zumindest einen Graben (T) eingebracht und zur Ausbildung der Galvanisierungsmaske (R) fotolithographisch strukturiert wird.

8. Verfahren nach Patentanspruch 7,
**dadurch gekennzeichnet, dass** der fotosensitive Lack einen Negativresist darstellt.

9. Verfahren nach einem der Patentansprüche 1 bis 8,
**dadurch gekennzeichnet, dass** in Schritt e) eine Vielzahl von galvanischen Metallschichten und insbesondere eine Cu/NiP- oder Cu/AuSn-Schichtenfolge als Galvanik-Füllmaterial (GF) ausgebildet wird.

10. Verfahren nach einem der Patentansprüche 1 bis 9,
**dadurch gekennzeichnet, dass** in Schritt f) ein Plasma-Ätzen mit nasschemischen Ätzen zum Entfernen der Galvanisierungsmaske (R) und
ein weiteres nasschemisches Ätzen zum Entfernen der darunterliegenden Galvanik-Keimschicht (SL) unter Verwendung des Galvanik-Füllmaterials (GF) als Maske durchgeführt wird.

11. Verfahren nach einem der Patentansprüche 1 bis 10,
**dadurch gekennzeichnet, dass** in Schritt h) ein mechanisches Schleifen mit nachfolgendem nasschemischen Ätzen durchgeführt wird.

12. Verfahren nach einem der Patentansprüche 1 bis 11,
**dadurch gekennzeichnet, dass** in Schritt h) bis zu einer Enddicke (D_{E}) von 5 µm bis 200 µm gedünnt wird.

13. Verfahren nach einem der Patentansprüche 1 bis 12,
**gekennzeichnet durch**
den weiteren Schritt i) Ausbilden einer Rückseitenmetallisierung (RM) an der Rückseite des gedünnten Substrats (1A).

## Claims

1. Method for producing a fracture-resistant disc-shaped object comprising the following steps:
a) preparing a substrate (1, B, I) having an initial thickness (D_{A}) and a sawing frame (4);
b) forming at least one trench (T) having a trench depth (h) in the region of the sawing frame (4) at a front side of the substrate (1, B, I);
c) forming an electrically conductive plating seed layer (SL) at the surface of the substrate and of the trench (T);
d) forming a plating mask (R) at least in the region of the trench (T);
e) carrying out the plating in order to fill the non-masked regions by means of the plating seed layer (SL);
f) removing the plating mask (R) and the underlying plating seed layer (SL) in order to uncover the trench (T);
g) filling the trench (T) with polyimide or photoimide; and
h) thinning the substrate (1) from its rear side to a final thickness (D_{E}) for realizing a thinned substrate (1A), wherein the final thickness (D_{E}) of the thinned substrate (1A) is smaller than the trench depth (h) of the trench (T).

2. Method according to Patent Claim 1,
**characterized in that**, in step a), vertical power transistors (S, G, D) are formed in a semiconductor wafer (1) of a first conduction type (n⁻).

3. Method according to Patent Claim 1 or 2,
**characterized in that**, in step b), laser cutting, plasma etching, wet-chemical etching, light-induced etching, anodic etching and/or sawing are/is carried out.

4. Method according to any of Patent Claims 1 to 3,
**characterized in that**, in step c), a PVD method is carried out for forming the plating seed layer (SL) over the whole area.

5. Method according to Patent Claim 4,
**characterized in that** the plating seed layer (SL) has a diffusion barrier layer.

6. Method according to Patent Claim 4 or 5,
**characterized in that** the plating seed layer (SL) has a TaN/Cu or TiN/Cu layer sequence having a thickness of less than 100 nm.

7. Method according to any of Patent Claims 1 to 6,
**characterized in that**, in step d), a photosensitive resist having a thickness of 20 µm to 200 um is spin-coated over the whole area and introduced into the at least one trench (T) and patterned photolithographically in order to form the plating mask (R).

8. Method according to Patent Claim 7,
**characterized in that** the photosensitive resist constitutes a negative resist.

9. Method according to any of Patent Claims 1 to 8,
**characterized in that**, in step e), a multiplicity of electrolytic metal layers and in particular a Cu/NiP or Cu/AuSn layer sequence is formed as the plating filling material (GF).

10. Method according to any of Patent Claims 1 to 9,
**characterized in that** step f) involves carrying out a plasma etching by means of wet-chemical etching for removing the plating mask (R) and
a further wet-chemical etching for removing the underlying plating seed layer (SL) using the plating filling material (GF) as a mask.

11. Method according to any of Patent Claims 1 to 10,
**characterized in that** step h) involves carrying out mechanical grinding with subsequent wet-chemical etching.

12. Method according to any of Patent Claims 1 to 11,
**characterized in that** step h) involves thinning to a final thickness (D_{E}) of 5 µm to 200 µm.

13. Method according to any of Patent Claims 1 to 12, **characterized by**
the further step i) forming a rear-side metallization (RM) at the rear side of the thinned substrate (1A).

## Revendications

1. Procédé de fabrication d'un objet en forme de disque résistant à la rupture, comprenant les stades dans lesquels :
a) on prépare un substrat (1, B, I) ayant une épaisseur (D_{A}) initiale et un cadre (4) de sciage ;
b) on forme au moins un sillon (T) ayant une profondeur (H) dans la zone du cadre (4) de sciage sur une face avant du substrat (1, B, I) ;
c) on forme une couche (SL) de germe galvanique et conductrice de l'électricité à la surface du substrat et du sillon (T) ;
d) on forme un masque (R) de galvanisation, au moins dans la zone du sillon (T) ;
e) on effectue une galvanisation pour remplir de la couche (SL) de germe galvanique les zones non masquées ;
f) on élimine le masque (R) de galvanisation et la couche (SL) de germe galvanique sous-jacente pour mettre à nu le sillon (T) ;
g) on remplit le sillon (T) de polyimide ou d'un imide photosensible ; et
h) on amincit le substrat (1) par sa face arrière jusqu'à une épaisseur (D_{E}) finale pour la réalisation d'un substrat (1A) aminci, l'épaisseur (D_{E}) finale du substrat (1A) aminci étant plus petite que la profondeur (h) du sillon (T).

2. Procédé suivant la revendication 1,
**caractérisé en ce que**, dans le stade a), on forme, dans une tranche (1) semiconductrice d'un premier type (n⁻) de conduction, des transistors (S, G, D) de puissance verticaux.

3. Procédé suivant la revendication 1 ou 2,
**caractérisé en ce que**, dans le stade b), on effectue une coupe par laser, une attaque par plasma, une attaque chimique en voie humide, une attaque induite par de la lumière, une attaque anodique et/ou un sciage.

4. Procédé suivant l'une des revendications 1 à 3,
**caractérisé en ce que**, dans le stade c), on effectue un procédé PVD pour former la couche (SL) de germe galvanique sur toute la surface.

5. Procédé suivant la revendication 4,
**caractérisé en ce que** la couche (SL) de germe galvanique comporte une couche formant barrière de diffusion.

6. Procédé suivant la revendication 4 ou 5,
**caractérisé en ce que** la couche (SL) de germe galvanique comporte une succession de couches TaN/Cu ou TiN/Cu d'une épaisseur plus petite que 100 nm.

7. Procédé suivant l'une des revendications 1 à 6,
**caractérisé en ce que**, dans le stade d), on projette sur toute la surface un vernis photosensible d'une épaisseur de 20 µm à 200 µm, on l'introduit dans le au moins un sillon (T) et on le structure par photolithographie pour la formation du masque (R) de galvanisation.

8. Procédé suivant la revendication 7,
**caractérisé en ce que** le vernis photosensible constitue une réserve négative.

9. Procédé suivant l'une des revendications 1 à 8,
**caractérisé en ce que**, dans le stade e), on forme une forme une pluralité de couches métalliques galvaniques, et notamment une succession Cu/NiP ou Cu/AuSn, comme matière (GF) de remplissage galvanique.

10. Procédé suivant l'une des revendications 1 à 9,
**caractérisé en ce que**, dans le stade f), on effectue une attaque au plasma avec une attaque chimique en voie humide pour éliminer le masque (R) de galvanisation et
une autre attaque chimique en voie humide pour éliminer la couche (SL) de germe galvanique sous-jacente en utilisant la matière (GF) de remplissage galvanique comme masque.

11. Procédé suivant l'une des revendications 1 à 10,
**caractérisé en ce que**, dans le stade h), on effectue un polissage mécanique avec attaque chimique en voie humide venant ensuite.

12. Procédé suivant l'une des revendications 1 à 11,
**caractérisé en ce que**, dans le stade h), on amincit jusqu'à une épaisseur (D_{E}) de 5 µm à 200 µm.

13. Procédé suivant l'une des revendications 1 à 12,
**caractérisé par** le stade i) supplémentaire de formation d'une métallisation (RM) de face arrière sur la face arrière du substrat (1A) aminci.
